# EUROPEAN PATENT SPECIFICATION

(11) **EP 4 199 354 B1**
(45) Date of publication and mention of the grant of the patent: **02.12.2026**
(21) Application number: 22211639.4
(22) Date of filing: 06.12.2022
(51) Int. Cl.: H03K 5/26

(54) **CLOCK DRIFT MONITOR**
TAKTDRIFTMONITOR
MONITEUR DE DÉRIVE D'HORLOGE

(30) Priority: 17.12.2021 US 202117553917
(43) Date of publication of application: 21.06.2023
(73) Proprietor: Hamilton Sundstrand Corporation, Charlotte, NC 28217-4578 (US)
(72) Inventor: WILSON, Michael A., Scottsdale, AZ (US); HESS, Gary L., Somers, CT (US)
(74) Representative: Dehns

(56) References cited:
- US-A1- 2008 088 351
- US-A1- 2015 227 162
- US-A1- 2019 288 697

## Description

### BACKGROUND

The present invention relates to clock synchronization, and more specifically, to an XOR clock drift monitor.

Many avionics controls use multiple independent clock sources to maintain system redundancy. These clock sources may run asynchronously but must remain reasonably close in frequency to ensure that independent processing elements remain synchronized. Therefore, there may be a need to monitor the clock drift between independent clock sources.

US 2015/227162 A1 relates to switching between different clocks.

### BRIEF DESCRIPTION

According to an aspect of the invention, a method for monitoring clock drift is provided as claimed in claim 1. The method comprises receiving a first clock signal from a first clock source and a second clock signal from a second clock source; generating a switching output based on the first clock signal and the second clock signal, wherein the switching output is proportional to a phase difference between the first clock signal and the second clock signal; detecting a rising edge and a falling edge of the switching output; comparing the rising edge to a configurable threshold to determine if a fault condition exists indicating clock drift between the first clock signal and the second clock signal; and providing an indication of the fault condition based at least in part on the comparison.

Further embodiments include receiving the first clock signal and the second clock signal at an exclusive-OR gate.

Further embodiments include that the exclusive-OR gate generates the switching output based on the first clock signal and the second clock signal.

Further embodiments include that the switching output is filtered using a Schmitt trigger buffer to generate a square wave signal having a duty cycle.

Further embodiments include that the duty cycle indicates a phase difference between the first clock signal and the second clock signal.

In addition to one or more of the features described herein, the configurable threshold corresponds to an extended falling edge that is triggered by the falling edge of the switching output.

In addition to one or more of the features described herein, the method includes receiving the detected rising edge and the extended falling edge at an AND gate to determine if the rising edge overlaps the extended falling edge.

Further embodiments include providing the indication of the fault condition responsive to determining the rising edge overlaps the extended falling edge.

Further embodiments include that a frequency of the first clock signal is different than a frequency of the second clock signal.

Further embodiments include using a first clock signal and a second clock signal are received at a first clock divider and a second clock divider, respectively, wherein the first clock divider and the second divider are used to obtain a nominal signal of the first clock signal and the second clock signal for the comparison.

According to a further aspect of the invention, a circuit for monitoring clock drift is provided as claimed in claim 7. The circuit comprises an XOR gate configured to receive a first clock signal from a first clock source and a second clock signal from a second clock source, wherein the XOR logic gate is further configured to generate a switching output based on an XOR operation of the first clock signal and the second clock signal; a rising edge detector and a falling edge detector configured to detect a rising edge and a falling edge of the switching output; and an AND gate configured to threshold compare a rising edge detection signal provided by the the rising edge detector to a configurable threshold to determine if a fault condition exists indicating clock drift between the first clock signal and the second clock signal, and provide an indication of the fault condition based at least in part on the comparison.

Further embodiments include that the switching output is proportional to a phase difference between the first clock signal and the second clock signal.

Further embodiments include that the XOR gate is configured to generate the switching output based on the first clock signal and the second clock signal.

Further embodiments include a Schmitt trigger buffer configured to receive the switching output from the XOR gate and generate a square wave signal having a duty cycle.

Further embodiments include that the duty cycle indicates a phase difference between the first clock signal and the second clock signal.

In addition to one or more of the features described herein, the circuit further includes a re-triggerable one-shot circuit configured to generate an extended falling edge signal that is triggered by the falling edge of the switching output, wherein the extended falling edge signal corresponds to the configurable threshold.

Further embodiments include that the AND gate is configured to receive the rising edge detection signal and the extended falling edge signal to determine if the rising edge overlaps the extended falling edge to compare the rising edge to the configurable threshold.

Further embodiments include that the AND gate that is configured to provide an output indicating the fault condition responsive to determining the rising edge overlaps the extended falling edge.

Further embodiments include that a frequency of the first clock signal is different than a frequency of the second clock signal.

Further embodiments include a first clock divider and a second clock divider that is configured to receive the first clock signal and the second clock, respectively, and the first clock divider and the second divider are configured to obtain a nominal signal of the first clock signal and the second clock signal for the comparison.

The foregoing features and elements as well as the operation thereof will become more apparent in light of the following description and the accompanying drawings. It should be understood, however, that the following description and drawings are intended to be illustrative and explanatory in nature and non-limiting.

### BRIEF DESCRIPTION OF THE DRAWINGS

The following descriptions should not be considered limiting in any way. With reference to the accompanying drawings, like elements are numbered alike:
FIG. 1 depicts a circuit diagram for the clock drift monitoring circuit in accordance with one or more embodiments of the disclosure;
FIG. 2 depicts a timing diagram where a fault is detected by the clock drift monitoring circuit in accordance with one or more embodiments of the disclosure;
FIG. 3 depicts a timing diagram where no fault is detected by the clock drift monitoring circuit in accordance with one or more embodiments of the disclosure; and
FIG. 4 depicts a flowchart of a method for monitoring clock drift using the clock drift monitoring circuit in accordance with one or more embodiments of the disclosure.

### DETAILED DESCRIPTION

An exclusive-OR (XOR) clock drift circuit can be used to monitor the relative frequency of two independent clock sources. A "fault" output signal generated by the XOR clock drift circuit may comprise a digital logic signal, which may be read by any general-purpose digital input buffer. The "fault" output signal will assert if the frequency difference between the two clocks exceeds a predetermined threshold.

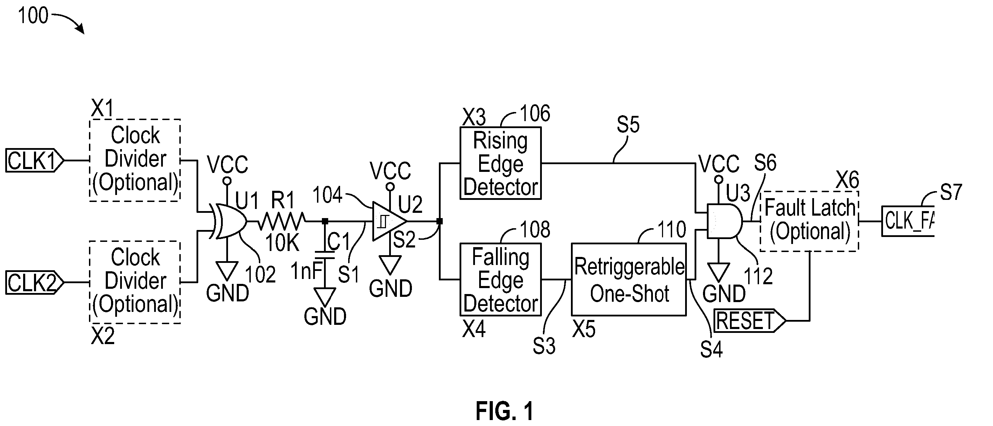

Referring to FIG. 1, a circuit 100 for monitoring clock drift in accordance with one or more embodiments of the disclosure is provided. The circuit 100 comprises a plurality of components and includes an exclusive-OR (XOR) gate 102, a buffer 104, a rising edge detector 106, a falling edge detector 108, a re-triggerable one-shot 110, and an AND gate 112 to implement monitoring the clock drift between a first clock signal CLK1 and a second clock signal CLK2. The sources for the first clock signal and the second clock signal are not shown. Upon receiving the first clock signal and the second clock signal, the XOR gate 102 generates an output signal which is provided to the buffer 104. The XOR gate 102 produces a switching output with a duty cycle that is proportional to the phase difference between the first and second clock signals. For example, the phase difference of 0° degrees has a duty cycle of 0%; the phase difference of ±90° degrees has a duty cycle of 50%; and the phase difference of ±180° degrees has a duty cycle of 100%.

In one or more embodiments of the disclosure, when the first clock signal and the second clock signal are different frequencies, the clock signals may be provided to a first clock divider circuit and a second clock divider circuit, respectively, to obtain nominal first clock signals and second clock signals prior to being provided to the XOR gate 102. In a non-limiting example, if CLK1 is 40 MHz and CLK2 is 30 MHz, then dividing the CLK1 by 4 and CLK2 by 3 using the clock divider circuits can result in a common clock outputs of nominal 10 MHz.

The output of the XOR gate 102 can be provided to a filter, such as a low-pass resistor-capacitor (RC), to generate a filtered XOR signal S1. The filtered XOR signal S1 is provided to the buffer 104. In such an instance, the cutoff frequency of the RC low-pass filter should be set above the maximum expected CLK1-CLK2 frequency difference, but below the nominal clock frequencies. The output of the filter will be nominally centered at VCC/2.

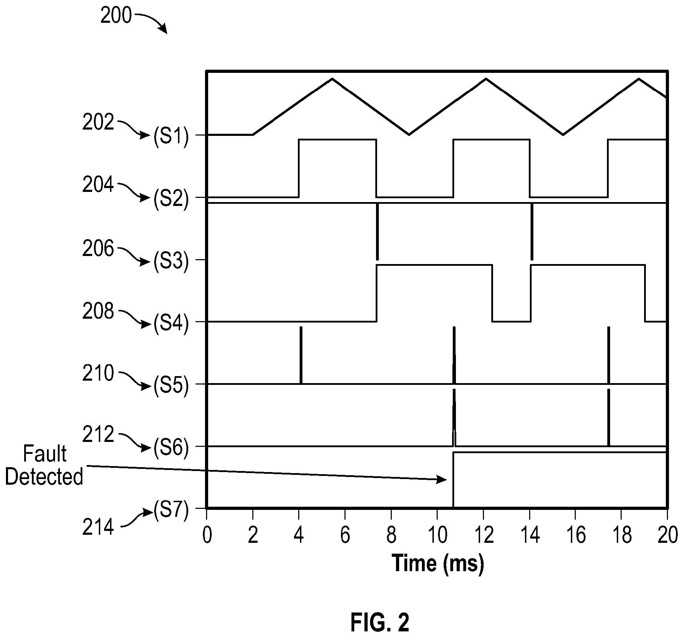

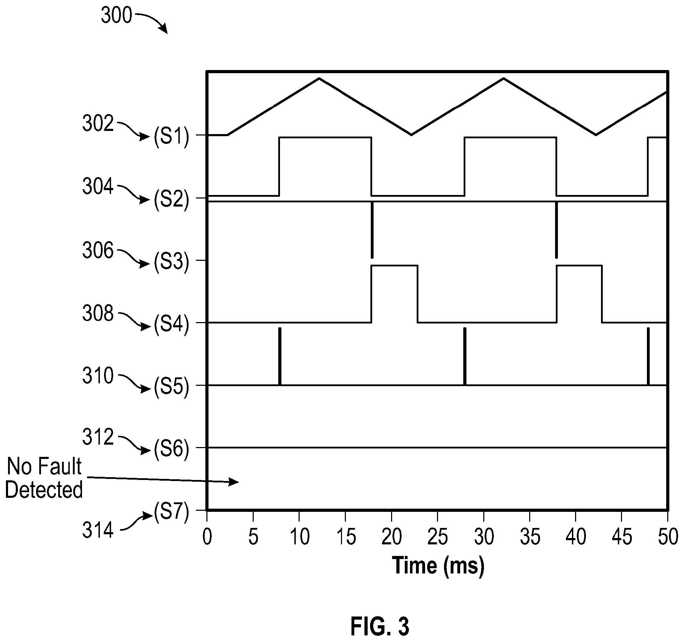

The output of the buffer 104 provides a filtered buffer signal S2 to the rising edge detector 106 and the falling edge detector 108. In one or more embodiments of the disclosure, the buffer 104 is a Schmitt trigger buffer that can be configured to remove the noise from the input signal and generate a square wave. The rising edge detector 106 is configured to detect the rising edge of the filtered buffer signal S2. A waveform representing the rising edge signal S5 is shown in FIGS. 2 and 3. The falling edge detector 108 is configured to detect the falling edge of the filtered buffer signal S2. A waveform representing the falling edge signal S3 is shown in FIGS. 2 and 3. The rising edge detector 106 can comprise various arrangements of circuit components to detect the rising edge of the signal. Similarly, the falling edge detector 108 can comprise various arrangements of circuit components to detect the falling edge of the signal. Any known configuration of the rising edge detector 106 or falling edge detector 108 can be implemented into the circuit 100.

The output of the falling edge detector 108 provides the falling edge signal to the re-triggerable one-shot 110 which is configured to output an extended falling edge signal S4 of a predetermined duration. In other words, the re-triggerable one-shot 110 extends the high portion of the signal for a configurable period. The extended falling edge signal S4 is output of the one-shot 110 and the output of the rising edge detector 106 is provided to the AND gate 112 of the circuit 100. The AND gate 112 detects if an overlap of the received signals occurs. If an overlap between the rising edge and the output of the re-triggerable one-shot 110 is detected at the AND gate 112, a logic high representing an overlap signal S6 is output of the AND gate 112. The overlap can indicate a fault condition where the first clock and the second clock have drifted beyond an acceptable threshold duration, where the threshold duration is set by the one-shot 110. If the rising edge and the output of the re-triggerable one-shot 110 do not overlap, then there is no fault condition detected at the AND gate 112 or the first clock and the second clock are operating within a predefined threshold of one another. In one or more embodiments of the disclosure, the output of the AND gate 112 can be provided to a fault latch circuit. The fault latch circuit may be used in scenarios where the downstream processing element(s) is unable to read the output of the AND gate 112 often enough. In such a scenario, a fault signal (clk_fault) S7 is provided to a downstream processing element or process.

One or more illustrative embodiments of the disclosure are described herein. Such embodiments are merely illustrative of the scope of this disclosure and are not intended to be limiting in any way. Accordingly, variations, modifications, and equivalents of embodiments disclosed herein are also within the scope of this disclosure.

FIG. 2 depicts a timing diagram 200 illustrating an example where a fault is detected by the clock drift monitoring circuit 100 in accordance with one or more embodiments of the disclosure. The waveforms of the timing diagram 200 are generated at various points in the circuit 100 and will be discussed below. The x-axis of the timing diagram 200 represents the time measured in milliseconds (ms), and the y-axis represents the amplitude of the voltage of the waveforms. The waveform 202 represents the filtered XOR signal S1 that is output from the XOR gate which receives the first clock signal and the second clock signal.

The waveform 204 represents the filtered buffer signal S2 which provides a square wave with a frequency equal to the absolute value of the frequency difference between the two monitored clocks, the first clock signal and the second clock signal. The waveform 206 and the waveform 210 represent the detection of the falling edge signal S3 and the rising edge signal S5, respectively. The waveform 208 represents the extended falling edge signal S4 that is triggered by the falling edge signal S3 of the waveform 204. The extended falling edge signal can be configured to correspond to a threshold to determine an unacceptable clock drift. For example, the extended falling edge signal can be configured to remain high for 5ms, 10ms, 15ms, etc. based on the circuit component values or configuration that is selected for the re-triggerable one shot 110.

The waveform 212 represents an overlap detection signal S6 when the extended falling edge signal S4 overlaps the rising edge signal S5. This overlap indicates a fault condition where the first clock signal and the second clock signal have drifted over an acceptable amount. As a result, the waveform representing the fault signal S7 can be provided to a downstream process.

FIG. 3 depicts a timing diagram 300 illustrating an example where no fault is detected by the clock drift monitoring circuit in accordance with one or more embodiments of the disclosure. The waveforms 302, 304, 306, 310 are similar to the waveforms illustrated in FIG. 2. **In** this non-limiting example, the extended falling edge signal S4 is triggered by the falling edge of the filtered buffer signal S2. The duration of the high portion of the extended falling edge signal S4 is configured to be shorter than the extended falling edge signal S4 shown in FIG. 2. As a result, there is no overlap detected between the extended falling edge signal S4 and the rising edge signal S5, and no overlap is detected in signal S6. Therefore, a no-fault signal S7 is produced as shown in FIG. 3.

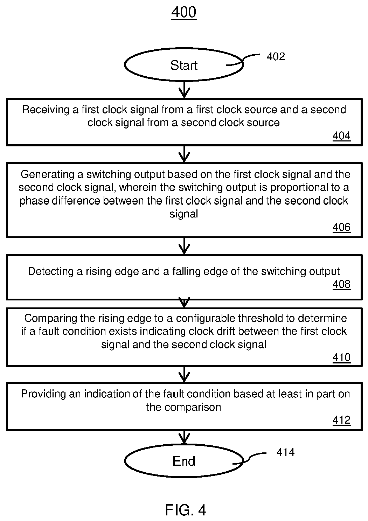

Now referring to FIG. 4, a flowchart of a method 400 for monitoring clock drift in accordance with one or more embodiments of the disclosure is provided. The method 400 begins at block 402 and continues to block 404. At block 404, the XOR logic gate of the clock drift circuit receives a first clock signal from a first clock source and a second clock signal from a second clock source. The first clock signal and the second clock signal may originate from independent clock sources. **In** one or more embodiments of the disclosure, the first clock signal and the second clock signal, when having different frequencies, may be provided a first clock divider circuit and a second clock divider circuit, respectively, to obtain nominal first and second clock signals that can be appropriately compared at the XOR logic gate.

At block 406, the XOR logic gate generates a switching output based on the first clock signal and the second clock signal, wherein the switching output is proportional to a phase difference between the first clock signal and the second clock signal. In one or more embodiments, the switching output of the XOR gate can be filtered using a Schmitt trigger buffer to generate a square wave signal having a duty cycle. The duty cycle of the switching output of the XOR gate corresponds to a phase difference between the first clock signal and the second clock signal.

At block 408, a rising edge detector and a falling edge detector are used to detect the rising edge and the falling edge of the switching output. The falling edge signal can be used to trigger a re-triggerable one-shot circuit to generate an extended falling edge signal. The duration of the extended falling edge signal corresponds to the configurable threshold duration to determine whether the clock drift between the first clock signal and the signal clock signal is within an acceptable tolerance. The extended falling edge signal can be configured according to various applications. At block 410, a logic gate compares the rising edge to a configurable threshold to determine if a fault condition exists indicating a clock drift between the first clock signal and the second clock signal. The comparison comprises receiving the rising edge and the extended falling edge at a logic gate (e.g., AND gate) to determine if the rising edge of the switching output overlaps the extended falling edge. If the rising edge overlaps the extended falling edge, an indication of the fault condition can be provided to a downstream process.

At block 412, the logic gate provides an indication of the fault condition based at least in part on the comparison. In one or more embodiments of the disclosure, the indication of the fault condition may be provided to a latch circuit and further provided to a downstream process for analysis.

The method 400 ends at block 414. The process flow diagram of FIG. 4 is not intended to indicate that the operations of the method 400 are to be executed in any particular order, or that all of the operations of the method 400 are to be included in every case. Additionally, the method 400 can include any suitable number of additional operations
Technical effects of embodiments of the present disclosure include monitoring clock drift without the use of frequency counters, phase-locked loops (PLL), or other high-frequency measurement techniques. In addition, high-speed clock signals need not be routed to each individual processing element which further simplifies the board layout of the design.

A detailed description of one or more embodiments of the disclosed apparatus and method are presented herein by way of exemplification and not limitation with reference to the Figures.

The term "about" is intended to include the degree of error associated with measurement of the particular quantity based upon the equipment available at the time of filing the application.

The terminology used herein is for the purpose of describing particular embodiments only and is not intended to be limiting of the present disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

While the present disclosure has been described with reference to an exemplary embodiment or embodiments, it will be understood by those skilled in the art that various changes may be made and equivalents may be substituted for elements thereof without departing from the scope of the present invention that is defined by the appended claims. In addition, many modifications may be made to adapt a particular situation or material to the teachings of the present invention without departing from the scope thereof. Therefore, it is intended that the present invention not be limited to the particular embodiment disclosed as the best mode contemplated for carrying out this present invention, but that the present invention will include all embodiments falling within the scope of the claims.

## Claims

1. A method for monitoring clock drift, the method comprising:
Receiving (404) a first clock signal from a first clock source and a second clock signal from a second clock source;
generating (406) a switching output based on the first clock signal and the second clock signal, wherein the switching output is proportional to a phase difference between the first clock signal and the second clock signal;
detecting (408) a rising edge and a falling edge of the switching output;
generating a rising edge detection signal (S5) based on the rising edge and a falling edge detection signal (S4) based on the falling edge;
delivering the rising edge detection signal (S5) to a first input of an AND gate;
delivering the falling edge detection signal (S4) to a re-triggerable one-shot circuit;
outputting, by the re-triggerable one-shot circuit, an extended falling edge signal of a predetermined duration;
delivering the extended falling edge signal to a second input of the AND gate;
comparing (410), by the AND gate, the rising edge to a configurable threshold to determine if a fault condition exists indicating clock drift between the first clock signal and the second clock signal, wherein the extended falling edge signal corresponds to the configurable threshold; and
providing (412) an indication of the fault condition based at least in part on the comparison.

2. The method of claim 1, wherein receiving the first clock signal and the second clock signal comprises receiving the first clock signal and the second clock signal at an exclusive-OR gate.

3. The method of claim 2, wherein the exclusive-OR gate generates the switching output based on the first clock signal and the second clock signal.

4. The method of claim 3, wherein the switching output is filtered using a Schmitt trigger buffer to generate a square wave signal having a duty cycle, and optionally
wherein the duty cycle indicates a phase difference between the first clock signal and the second clock signal.

5. The method of any of claims 1 to 4, wherein comparing the rising edge to the configurable threshold comprises receiving the rising edge and the extended falling edge at the AND gate to determine if the rising edge overlaps the extended falling edge, and optionally
further comprising providing the indication of the fault condition responsive to determining the rising edge overlaps the extended falling edge.

6. The method of any preceding claim, wherein a frequency of the first clock signal is different than a frequency of the second clock signal, and optionally
wherein the first clock signal and the second clock signal are received at a first clock divider and a second clock divider, respectively, wherein the first clock divider and the second divider are used to obtain a nominal signal of the first clock signal and the second clock signal for the comparison.

7. A circuit for monitoring clock drift, the circuit comprising:
an XOR gate (102) configured to receive a first clock signal from a first clock source and a second clock signal from a second clock source, wherein the XOR logic gate is further configured to generate a switching output based on an XOR operation of the first clock signal and the second clock signal;
a rising edge detector (106) and a falling edge detector (108) configured to detect a rising edge and a falling edge of the switching output, respectively; and
an AND gate (112) configured to threshold compare a rising edge detection signal provided by the rising edge detector to a configurable threshold to determine if a fault condition exists indicating clock drift between the first clock signal and the second clock signal, and provide an indication of the fault condition based at least in part on the comparison,
further comprising a re-triggerable one-shot circuit (110) configured to generate an extended falling edge signal that is triggered by the detected falling edge of the switching output, wherein the extended falling edge signal corresponds to the configurable threshold.

8. The circuit of claim 7, wherein the switching output is proportional to a phase difference between the first clock signal and the second clock signal.

9. The circuit of claim 8, wherein the XOR gate (102) is configured to generate the switching output based on the first clock signal and the second clock signal.

10. The circuit of claim 9, further comprising a Schmitt trigger buffer configured to receive the switching output from the XOR gate (102) and generate a square wave signal having a duty cycle, optionally
wherein the duty cycle indicates a phase difference between the first clock signal and the second clock signal.

11. The circuit of any of claims 7 to 10, wherein the AND gate (112) is configured to receive the rising edge detection signal and the extended falling edge signal to determine if the rising edge overlaps the extended falling edge to compare the rising detection signal to the configurable threshold, optionally
wherein the AND gate is configured to provide an output indicating the fault condition responsive to determining the rising edge overlaps the extended falling edge.

12. The circuit of any of claims 7 to 11, wherein a frequency of the first clock signal is different than a frequency of the second clock signal.

13. The circuit of claim 12, further comprising a first clock divider and a second clock divider configured to receive the first clock signal and the second clock signal, respectively, and the first clock divider and the second divider are configured to obtain a nominal signal of the first clock signal and the second clock signal for the comparison.

## Patentansprüche

1. Verfahren zur Überwachung der Taktdrift, wobei das Verfahren Folgendes umfasst:
Empfangen (404) eines ersten Taktsignals von einer ersten Taktquelle und eines zweiten Taktsignals von einer zweiten Taktquelle;
Erzeugen (406) einer Schaltausgabe basierend auf dem ersten Taktsignal und dem zweiten Taktsignal, wobei die Schaltausgabe proportional zu einer Phasendifferenz zwischen dem ersten Taktsignal und dem zweiten Taktsignal ist;
Erkennen (408) einer steigenden Flanke und einer fallenden Flanke der Schaltausgabe;
Erzeugen eines Signals (S5) zur Erkennung einer steigenden Flanke basierend auf der steigenden Flanke und eines Signals (S4) zur Erkennung einer fallenden Flanke basierend auf der fallenden Flanke;
Zuführen des Signals (S5) zur Erkennung der steigenden Flanke zu einem ersten Eingang eines UND-Gatters;
Zuführen des Signals (S4) zur Erkennung der fallenden Flanke zu einer wiederauslösbaren monostabilen Schaltung;
Ausgeben eines Signals einer verlängerten fallenden Flanke von vorbestimmter Dauer durch die wiederauslösbare monostabile Schaltung;
Zuführen des Signals der verlängerten fallenden Flanke zu einem zweiten Eingang des UND-Gatters;
Vergleichen (410) der steigenden Flanke durch das UND-Gatter mit einem konfigurierbaren Schwellenwert, um zu bestimmen, ob ein Fehlerzustand vorliegt, der eine Taktdrift zwischen dem ersten und dem zweiten Taktsignal anzeigt, wobei das Signal der verlängerten fallenden Flanke dem konfigurierbaren Schwellenwert entspricht; und
Bereitstellen (412) einer Anzeige des Fehlerzustands mindestens teilweise basierend auf dem Vergleich.

2. Verfahren nach Anspruch 1, wobei das Empfangen des ersten Taktsignals und des zweiten Taktsignals Empfangen des ersten Taktsignals und des zweiten Taktsignals an einem Exklusiv-ODER-Gatter umfasst.

3. Verfahren nach Anspruch 2, wobei das Exklusiv-ODER-Gatter die Schaltausgabe basierend auf dem ersten Taktsignal und dem zweiten Taktsignal erzeugt.

4. Verfahren nach Anspruch 3, wobei die Schaltausgabe unter Verwendung eines Schmitt-Trigger-Puffers gefiltert wird, um ein Rechteckwellensignal mit einem Tastverhältnis zu erzeugen, und optional
wobei das Tastverhältnis eine Phasendifferenz zwischen dem ersten Taktsignal und dem zweiten Taktsignal anzeigt.

5. Verfahren nach einem der Ansprüche 1 bis 4, wobei das Vergleichen der steigenden Flanke mit dem konfigurierbaren Schwellenwert Empfangen der steigenden Flanke und der verlängerten abfallenden Flanke an dem UND-Gatter umfasst, um zu bestimmen, ob die steigende Flanke die verlängerte fallende Flanke überlappt, und optionalferner umfassend Bereitstellen der Anzeige des Fehlerzustands als Reaktion auf das Bestimmen, dass die steigende Flanke die verlängerte fallende Flanke überlappt.

6. Verfahren nach einem vorhergehenden Anspruch, wobei sich eine Frequenz des ersten Taktsignals von einer Frequenz des zweiten Taktsignals unterscheidet, und optional
wobei das erste Taktsignal und das zweite Taktsignal an einem ersten beziehungsweise einem zweiten Taktteiler empfangen werden, wobei der erste Taktteiler und der zweite Taktteiler verwendet werden, um ein nominales Signal des ersten Taktsignals und des zweiten Taktsignals für den Vergleich zu erhalten.

7. Schaltung zum Überwachen der Taktdrift, wobei die Schaltung Folgendes umfasst:
ein Exklusiv-ODER-Gatter (102), das dazu konfiguriert ist, ein erstes Taktsignal von einer ersten Taktquelle und ein zweites Taktsignal von einer zweiten Taktquelle zu empfangen, wobei das Exklusiv-ODER-Logikgatter ferner dazu konfiguriert ist, eine Schaltausgabe basierend auf einer Exklusiv-ODER-Verknüpfung des ersten Taktsignals und des zweiten Taktsignals zu erzeugen;
einen Detektor steigender Flanken (106) und einen Detektor fallender Flanken (108), die dazu konfiguriert sind, eine steigende beziehungsweise eine fallende Flanke der Schaltausgabe zu erkennen; und
ein UND-Gatter (112), das dazu konfiguriert ist, ein von dem Detektor steigender Flanken bereitgestelltes Signal zur Erkennung einer steigenden Flanke mit einem konfigurierbaren Schwellenwert zu vergleichen, um zu bestimmen, ob ein Fehlerzustand vorliegt, der eine Taktdrift zwischen dem ersten und dem zweiten Taktsignal anzeigt, und um mindestens teilweise basierend auf dem Vergleich eine Anzeige des Fehlerzustands bereitzustellen,
ferner umfassend eine wiederauslösbare monostabile Schaltung (110), die dazu konfiguriert ist, ein Signal einer verlängerten fallenden Flanke zu erzeugen, das durch die erkannte fallende Flanke der Schaltausgabe ausgelöst wird, wobei das Signal der verlängerten fallenden Flanke dem konfigurierbaren Schwellenwert entspricht.

8. Schaltung nach Anspruch 7, wobei die Schaltausgabe proportional zu einer Phasendifferenz zwischen dem ersten Taktsignal und dem zweiten Taktsignal ist.

9. Schaltung nach Anspruch 8, wobei das Exklusiv-ODER-Gatter (102) dazu konfiguriert ist, die Schaltausgabe basierend auf dem ersten Taktsignal und dem zweiten Taktsignal zu erzeugen.

10. Schaltung nach Anspruch 9, ferner umfassend einen Schmitt-Trigger-Puffer, der dazu konfiguriert ist, die Schaltausgabe von dem Exklusiv-ODER-Gatter (102) zu empfangen und ein Rechteckwellensignal mit einem Tastverhältnis zu erzeugen, optional
wobei das Tastverhältnis eine Phasendifferenz zwischen dem ersten Taktsignal und dem zweiten Taktsignal anzeigt.

11. Schaltung nach einem der Ansprüche 7 bis 10, wobei das UND-Gatter (112) dazu konfiguriert ist, das Signal zur Erkennung der steigenden Flanke und das Signal der verlängerten fallenden Flanke zu empfangen, um zu bestimmen, ob die steigende Flanke die verlängerte fallende Flanke überlappt, und um das Signal zur Erkennung der steigenden Flanke mit dem konfigurierbaren Schwellenwert zu vergleichen, optional
wobei das UND-Gatter dazu konfiguriert ist, als Reaktion auf das Bestimmen, dass die steigende Flanke die verlängerte fallende Flanke überlappt, eine Ausgabe bereitzustellen, der den Fehlerzustand anzeigt.

12. Schaltung nach einem der Ansprüche 7 bis 11, wobei sich die Frequenz des ersten Taktsignals von der Frequenz des zweiten Taktsignals unterscheidet.

13. Schaltung nach Anspruch 12, ferner umfassend einen ersten Taktteiler und einen zweiten Taktteiler, die dazu konfiguriert sind, das erste Taktsignal beziehungsweise das zweite Taktsignal zu empfangen, wobei der erste Taktteiler und der zweite Taktteiler dazu konfiguriert sind, ein nominales Signal des ersten Taktsignals und des zweiten Taktsignals für den Vergleich zu erhalten.

## Revendications

1. Procédé de surveillance de la dérive d'horloge, le procédé comprenant :
la réception (404) d'un premier signal d'horloge à partir d'une première source d'horloge et d'un second signal d'horloge à partir d'une seconde source d'horloge ;
la génération (406) d'une sortie de commutation sur la base du premier signal d'horloge et du second signal d'horloge, dans lequel la sortie de commutation est proportionnelle à une différence de phase entre le premier signal d'horloge et le second signal d'horloge ;
la détection (408) d'un front montant et d'un front descendant de la sortie de commutation ;
la génération d'un signal de détection de front montant (S5) sur la base du front montant et d'un signal de détection de front descendant (S4) sur la base du front descendant ;
la transmission du signal de détection de front montant (S5) à une première entrée d'une porte ET ;
la transmission du signal de détection de front descendant (S4) à un circuit monostable redéclenchable ;
la production, par le circuit monostable redéclenchable, d'un signal de front descendant prolongé d'une durée prédéterminée ;
la transmission du signal de front descendant prolongé à une seconde entrée de la porte ET ;
la comparaison (410), par la porte ET, du front montant à un seuil configurable pour déterminer s'il existe une condition de défaut indiquant une dérive d'horloge entre le premier signal d'horloge et le second signal d'horloge, dans lequel le signal de front descendant prolongé correspond au seuil configurable ; et
la fourniture (412) d'une indication de la condition de défaut sur la base, au moins en partie, de la comparaison.

2. Procédé selon la revendication 1, dans lequel la réception du premier signal d'horloge et du second signal d'horloge comprend la réception du premier signal d'horloge et du second signal d'horloge au niveau d'une porte OU exclusif.

3. Procédé selon la revendication 2, dans lequel la porte OU exclusif génère la sortie de commutation sur la base du premier signal d'horloge et du second signal d'horloge.

4. Procédé selon la revendication 3, dans lequel la sortie de commutation est filtrée à l'aide d'un tampon à trigger de Schmitt pour générer un signal carré ayant un rapport cyclique, et éventuellement
dans lequel le rapport cyclique indique une différence de phase entre le premier signal d'horloge et le second signal d'horloge.

5. Procédé selon l'une quelconque des revendications 1 à 4, dans lequel la comparaison du front montant au seuil configurable comprend la réception du front montant et du front descendant prolongé au niveau de la porte ET pour déterminer si le front montant chevauche le front descendant prolongé, et éventuellement
comprenant en outre la fourniture d'une indication de la condition de défaut en réponse à la détermination que le front montant chevauche le front descendant prolongé.

6. Procédé selon une quelconque revendication précédente, dans lequel une fréquence du premier signal d'horloge est différente d'une fréquence du second signal d'horloge, et éventuellement
dans lequel le premier signal d'horloge et le second signal d'horloge sont reçus respectivement au niveau d'un premier diviseur d'horloge et d'un second diviseur d'horloge, dans lequel le premier diviseur d'horloge et le second diviseur sont utilisés pour obtenir un signal nominal du premier signal d'horloge et du second signal d'horloge pour la comparaison.

7. Circuit de surveillance de la dérive d'horloge, le circuit comprenant :
une porte XOR (102) configurée pour recevoir un premier signal d'horloge à partir d'une première source d'horloge et un second signal d'horloge à partir d'une seconde source d'horloge, dans lequel la porte logique XOR est en outre configurée pour générer une sortie de commutation sur la base d'une opération XOR du premier signal d'horloge et du second signal d'horloge ;
un détecteur de front montant (106) et un détecteur de front descendant (108) configurés pour détecter respectivement un front montant et un front descendant de la sortie de commutation ; et
une porte ET (112) configurée pour comparer, selon un seuil, un signal de détection de front montant fourni par le détecteur de front montant à un seuil configurable afin de erdétminer s'il existe une condition de défaut indiquant une dérive d'horloge entre le premier signal d'horloge et le second signal d'horloge, et fournir une indication de la condition de défaut sur la base, au moins en partie, de la comparaison,
comprenant en outre un circuit monostable redéclenchable (110) configuré pour générer un signal de front descendant prolongé qui est déclenché par le front descendant détecté de la sortie de commutation, dans lequel le signal de front descendant prolongé correspond au seuil configurable.

8. Circuit selon la revendication 7, dans lequel la sortie de commutation est proportionnelle à une différence de phase entre le premier signal d'horloge et le second signal d'horloge.

9. Circuit selon la revendication 8, dans lequel la porte XOR (102) est configurée pour générer la sortie de commutation sur la base du premier signal d'horloge et du second signal d'horloge.

10. Circuit selon la revendication 9, comprenant en outre un tampon à trigger de Schmitt configuré pour recevoir la sortie de commutation à partir de la porte XOR (102) et générer un signal carré ayant un rapport cyclique, et éventuellement dans lequel le rapport cyclique indique une différence de phase entre le premier signal d'horloge et le second signal d'horloge.

11. Circuit selon l'une quelconque des revendications 7 à 10, dans lequel la porte ET (112) est configurée pour recevoir le signal de détection de front montant et le signal de front descendant prolongé afin de déterminer si le front montant chevauche le front descendant prolongé pour comparer le signal de détection de front montant au seuil configurable, éventuellement
dans lequel la porte ET est configurée pour fournir une sortie indiquant la condition de défaut en réponse à la détermination que le front montant chevauche le front descendant prolongé.

12. Circuit selon l'une quelconque des revendications 7 à 11, dans lequel une fréquence du premier signal d'horloge est différente d'une fréquence du second signal d'horloge.

13. Circuit selon la revendication 12, comprenant en outre un premier diviseur d'horloge et un second diviseur d'horloge configurés pour recevoir respectivement le premier signal d'horloge et le second signal d'horloge, et le premier diviseur d'horloge et le second diviseur sont configurés pour obtenir un signal nominal du premier signal d'horloge et du second signal d'horloge pour la comparaison.
